# EUROPEAN PATENT SPECIFICATION

(11) **EP 4 535 411 B1**
(45) Date of publication and mention of the grant of the patent: **06.05.2026**
(21) Application number: 23202138.6
(22) Date of filing: 06.10.2023
(51) Int. Cl.: H10P 90/00, H10W 10/10

(54) **A METHOD FOR THINNING A SEMICONDUCTOR SUBSTRATE**
VERFAHREN ZUM DÜNNEN EINES HALBLEITERSUBSTRATS
PROCÉDÉ D'AMINCISSEMENT D'UN SUBSTRAT SEMI-CONDUCTEUR

(43) Date of publication of application: 09.04.2025
(73) Proprietor: IMEC VZW, 3001 Leuven (BE)
(72) Inventor: Beyne, Eric, 3001 Heverlee (BE); Witters, Liesbeth, 3210 Lubbeek (BE)
(74) Representative: Patent Department IMEC

(56) References cited:
- US-A1- 2017 084 628
- US-A1- 2018 145 030
- US-B1- 10 354 980

## Description

### Field of the Invention

The present invention is related to semiconductor processing, in particular to the extreme thinning of a substrate from the backside.

### State of the art

In semiconductor processing, active devices such as transistors and diodes are fabricated on the front side of a semiconductor substrate, such as a Si process wafer of 300 mm in diameter. On top of the devices, a multilayer interconnect structure is built, for routing signals to and from the devices. Traditionally, the delivery of power to the devices was also routed through this front side interconnect structure. However recent development has led to the integration of a back side power delivery network, built on the backside of the substrate. To realize this, extreme thinning of the substrate from the backside is required, to bring the substrate portion to a thickness of less than 500 nm, preferably even to the point of completely removing the Si substrate, leaving only the active Si devices. Also in stacked IC configurations, the substrate portion of IC chips needs to be thinned to similar extremely low thickness values.

Traditionally, thinning takes place by bonding the wafer face down to another process wafer or to a temporary carrier substrate, and removing the bulk of the wafer from the back side thereof, by applying grinding and polishing techniques.

A problem however is that no process wafer is perfectly flat. Standard 300mm diameter process wafers have a typical thickness of 775µm with a total thickness variation (TTV) of only 1 or a few micrometres. At full thickness this is a relative precision better than 0.2%. After wafer-to-wafer bonding, both the wafer that is to be thinned and the receiving (supporting) wafer are subject to such a thickness variation. Therefore, thinning a wafer from the backside to extremely low thickness values by grinding and polishing techniques alone is virtually impossible without negatively affecting the active devices in one or more areas of the wafer. When thinning down the wafer thickness to less than a few micrometres, the few micrometre TTV variations dominate the problem.

A known solution to this problem is the production of ICs on a so-called SOI wafer (silicon-on-insulator), which comprises a thin oxide layer on the bulk silicon, and a thin epitaxially grown Si layer on top of the oxide. The devices and the multilayer interconnect structure are fabricated on this epitaxial Si layer, after which the wafer is bonded face down to another wafer or a carrier. Thinning from the back side by grinding and polishing is then stopped prior to reaching the oxide layer and the remaining bulk silicon is removed by wet etching, wherein the oxide layer acts as an etch stop layer. Thereafter the oxide itself is removed by etching selectively with respect to the epitaxially grown Si. Instead of an oxide layer, an epitaxially grown SiGe layer can be used as an etch stop layer.

These solutions are however technically complex and thereby increase the cost of the semiconductor fabrication process.

As an example, documents US 2017/084628 A1 and US 2018/145030 A1 disclose processes comprising a step of thinning an initial substrate using STI regions as an etch stop and the document US 10354980 B1 discloses a process of thinning an initial substrate using a conductive layer as an etch stop layer.

### Summary of the invention

The invention is related to a method in accordance with the appended claims. According to the method, a first crystalline semiconductor substrate is provided and a layer of semiconductor devices is produced on the front side thereof, in regions separated by dielectric-filled cavities, which may include shallow trench isolation regions, formed prior to the device processing. Additional layers such as the layers of a multilayer interconnect structure are formed on the device layer. The substrate is then flipped and bonded face down to a second substrate, following by the thinning of the crystalline first substrate from the back side. The thinning proceeds as far as possible without removing the full thickness of the first substrate anywhere across its surface, i.e. taking into account any intrinsic thickness variation of the first and second substrates. After this, an anisotropic etch is performed for removing additional material of the first substrate. In accordance with the invention, the in-plane dimensions of the device regions separated by the dielectric-filled cavities are configured so that the anisotropic etch is stopped by a crystallographic plane of the substrate material or by the dielectric material in said cavities, before it can reach said devices on the front side. Depending on the exact dimensions of the device regions and on possible depth differences between adjacent dielectric-filled cavities, the anisotropic etch may stop when a V-shaped groove is formed in the substrate material. After the anisotropic etch, a further dielectric material is deposited and planarized, along with remaining material of the first substrate.

The method thereby enables thinning the first substrate to a level that may be extremely close to the device layer, in the order of a few tens of nanometres for example, without running the risk of inadvertently removing or damaging devices in said device layer. An etch stop layer is not required and the method is applicable to a substrate that is integrally formed of the same material. The method thereby enables to simplify semiconductor process sequences and reduce costs.

The invention is in particular related to a method for producing a thinned semiconductor substrate, comprising the following consecutively performed steps:
- providing a first substrate having a planar front side and a planar back side, the first substrate being integrally formed of a crystalline semiconductor material or comprising on its front side a layer that is integrally formed of said crystalline semiconductor material,
- producing a device layer on the front side of the first substrate, said device layer comprising a plurality of semiconductor devices,
- producing additional layers on top of the device layer, ending with a layer having a planar top surface,
- permanently or temporarily bonding the first substrate to a second substrate by bonding said planar top surface to a bonding surface of the second substrate,
- thinning the first substrate from the back side thereof, wherein,
- before producing the device layer, and in at least one or more areas of the first substrate wherein said semiconductor devices are to be produced, cavities are produced through the front surface of the first substrate and into the crystalline semiconductor material of the first substrate, and said cavities are filled at least partially with a dielectric material, to thereby form dielectric-filled cavities,
- the devices in said one or more areas are produced in a plurality of regions located between two adjacent dielectric-filled cavities, and said devices are covered by an additional dielectric layer,
- at the end of the thinning step, the first substrate is reduced to a uniform layer of the crystalline semiconductor material remaining above said dielectric-filed cavities,
- after the thinning step, the crystalline semiconductor material is subjected to an anisotropic etch process,
- the in-plane dimensions of said regions located between two adjacent dielectric-filled cavities and the depth of said adjacent cavities are configured so that the anisotropic etch process stops on one or more of the following, without reaching the semiconductor devices :
   ∘ on crystallographic planes of the crystalline semiconductor material,
   ∘ on the dielectric material in the cavities,
   ∘ on said additional dielectric layer,
- the method further comprises the following steps, after the anisotropic etch process :
   o depositing a further dielectric material on the thinned back side of the first substrate,
   o planarizing said further dielectric material and remaining portions of the crystalline semiconductor material to a common planarized surface.
According to an embodiment, additional dielectric-filled cavities are also produced in areas of the first substrate wherein no semiconductor devices are to be produced.

According to an embodiment, the spacing between any adjacent pair of said additional dielectric-filled cavities is configured so that the anisotropic etch process does not reach the front side of the first substrate in said spacing.

According to an embodiment, at least some of the dielectric-filled cavities in said one or more areas of the first substrate wherein said semiconductor devices are to be produced, are shallow trench isolation regions.

According to an embodiment, the crystalline semiconductor material is crystalline silicon.

According to an embodiment, the first substrate is a silicon process wafer having planar front and back sides oriented along the crystallographic of silicon.

According to an embodiment, said in-plane dimensions and the depths of the dielectric-filled cavities are configured so that at least in some of said regions between two adjacent dielectric-filled cavities, the etch process ends when a V-shaped groove is formed in the material of the first substrate.

### Brief description of the figures

Figures 1a to 1c illustrate a process wafer and a layout of multiple dies on the wafer.
Figures 2 to 13 illustrate key steps of a method according to an embodiment of the invention.
Figures 14 to 16 illustrate an embodiment of a thinning method according to the invention wherein large areas of the bulk material of the process wafer are removed.
Figures 17 to 19 illustrate an embodiment wherein additional dielectric-filled cavities are included in order to prevent the removal of bulk wafer material up to the front side of the wafer.

### Detailed description of the invention

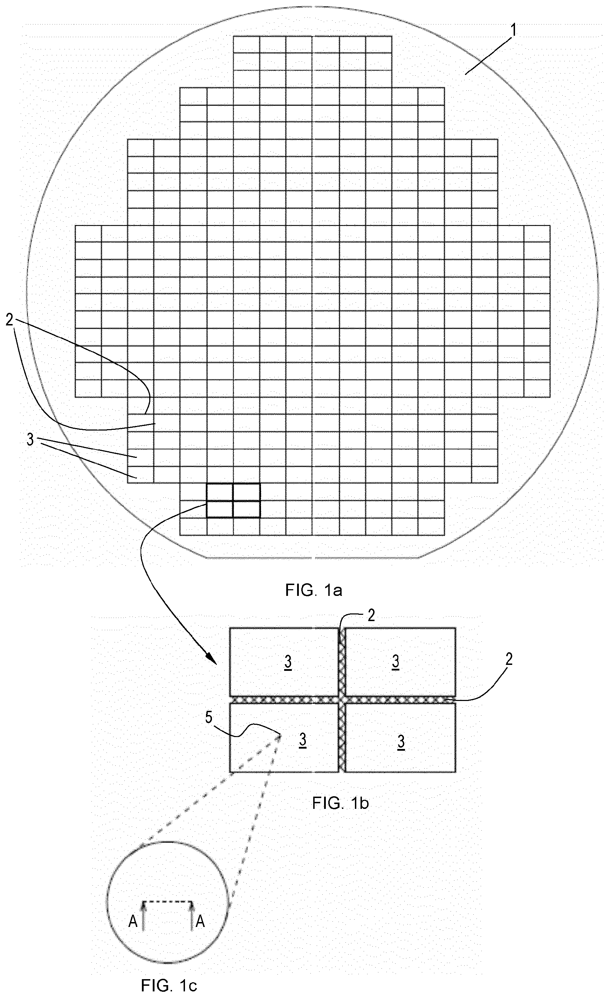

Figure 1a illustrates a process wafer 1 which may be a crystalline silicon wafer as generally known in the art, for example a standard process wafer of 300mm in diameter and having a thickness of a 775µm. Scribe lines 2 divide the wafer surface into a plurality of die areas 3. Four adjacent die areas 3 are represented in an enlarged image in Figure 1b. In these die areas 3, a given layout of active devices such as transistors and diodes is to be produced by a sequence of process steps. Each die area 3 may be in the order of a few tens of square millimeters and will be packed with nanometre-sized devices in the finished die. The scribe lines 2 are wide enough to enable singulating the finished dies, and may serve also as areas for printing auxiliary features such as metrology marks.

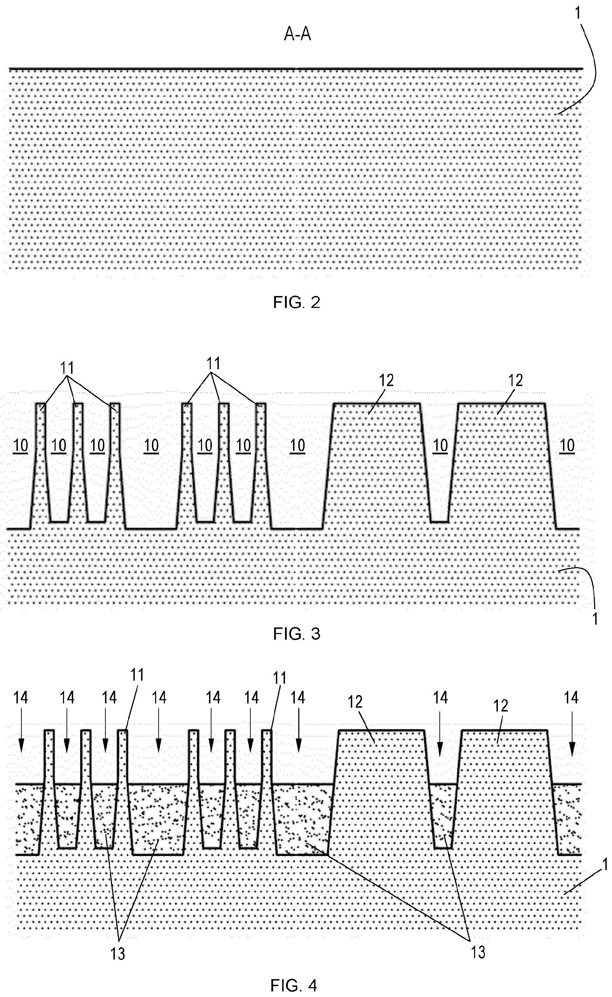

The method of the invention is explained on the basis of a nanometre sized section along line A-A in one die area 3, as indicated in Figure 1c, which shows an enlargement of a spot 5 in said die area. The section view of this small region is represented in a further enlarged view in Figure 2. Only a thin upper portion of the wafer 1 is shown, said portion having a thickness in the order of a few hundred nanometres. Preferably the wafer is integrally formed of a crystalline semiconductor material, although a composite wafer having a top layer of crystalline semiconductor material can also be applied in the method of the invention.

By lithography and etching, and as illustrated in Figure 3, a number of trenches 10 are formed through the front surface of the wafer 1, thereby defining semiconductor structures 11 and 12 separated by the trenches 10. In the exemplary case illustrated in Figure 3, two groups of fins 11 are created and two larger structures 12. The fins 11 may have a width at their top of a few nanometres or a few tens of nanometres for example and are typically formed with the purpose of processing finFET transistors. The larger areas 12 may be dummy areas or these areas 12 may be intended for processing other types of devices thereon such as planar transistors or diodes. Lithography and etch steps for producing patterns of this type are well known in the art and details thereof are therefore not required for explaining the present invention.

With reference to Figure 4, a dielectric material 13 is deposited and etched back selectively with respect to the fins 11 and the larger structures 12 to a level between the base and the top of said fins and structures. This is the creation of so-called shallow trench isolation regions (STI) 14, another concept well known in the art and applied for electrically isolating adjacent devices. The dielectric material 13 may be silicon oxide or any suitable material known for this purpose.

The dielectric-filled trenches 14 are embodiments of the broader term 'dielectric-filled cavities' used in appended claim 1. A trench is an elongate cavity, whose length is considerably longer than its width. STI regions for isolating devices are commonly produced in the form of such elongate cavities, i.e. trenches. However other areas on a chip may include dielectric-filled cavities of other shapes, in particular square or rectangular with a smaller difference between the length and the width of the rectangle. The presence of dielectric-filled cavities 14 plays a major role in the present invention, as will be explained later in this description. According to embodiments of the invention, dielectric-filled trenches or other cavities may be formed in areas where such trenches or cavities are not found in prior art designs, for example in the scribe lines 2 between adjacent die areas 3. The reason therefor will also become apparent further in this text. For the moment however, attention is again drawn to the small section A-A shown in Figures 1 to 4.

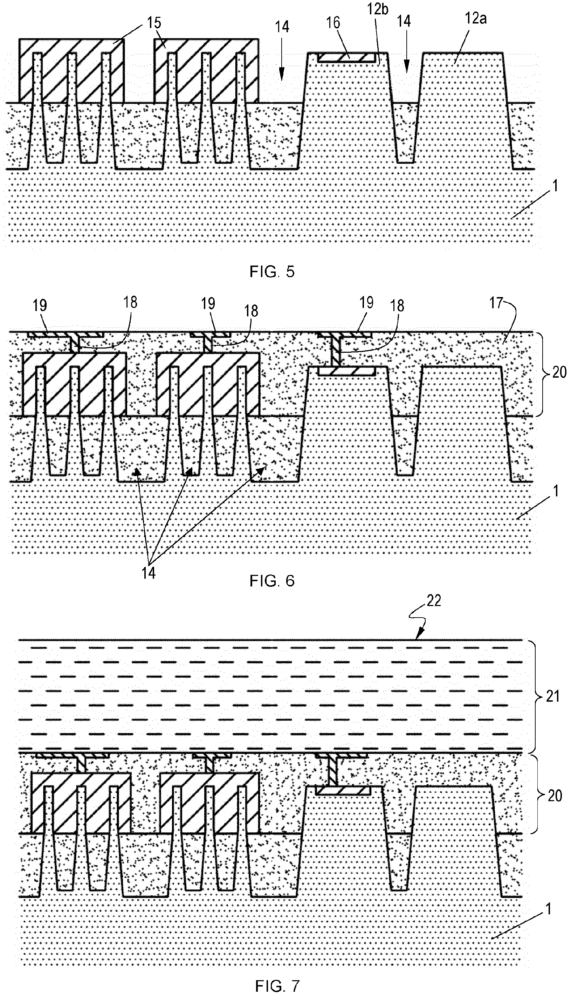

Following the creation of the dielectric-filled trenches 14, processing of the actual semiconductor devices is performed. This involves many process steps not described here in detail because these steps are known as such and do not form characteristic features of this invention. The result is represented in a simplified form in Figure 5. Device regions 15 are formed on the two groups of fins. These may be gate areas of finFETs for example. One of the larger areas 12a could be a dummy area while the other 12b has received a planar device 16 on its upper surface.

Further known steps are illustrated in Figure 6 and 7. A further dielectric material 17 is deposited and planarized. This is a material suitable to serve as a pre-metal dielectric (PMD), for example SiO₂ or a low-K material. Interconnect vias 18 and conductors 19 are produced in the PMD layer 17 by known techniques such as single or double damascene processes. The planarized PMD layer 17 with devices embedded therein is referred to as a 'device layer' 20 in the present context. This device layer may correspond to the front end of line portion of a chip, including also a first metallization level sometimes referred as the M0 level or the middle end of line.

On the device layer 20, further layers (see Figure 7) of interconnect vias and conductors are processed, which may correspond to the back of end line portion of an integrated circuit. In the embodiment shown, the BEOL portion is schematically represented as a layer 21 having a planar top surface 22.

The wafer is then flipped and attached face down to another substrate. For this purpose, the planar top surface 22 of the BEOL portion 21 may be the surface of a dielectric bonding layer formed for example of SiO₂ or SiCN, or a hybrid bonding layer comprising dielectric material and metal contact pads coplanar therewith. Such bonding layers are suitable for use in a well-known wafer to wafer direct bonding process which may involve a heating step for forming a strong bond.

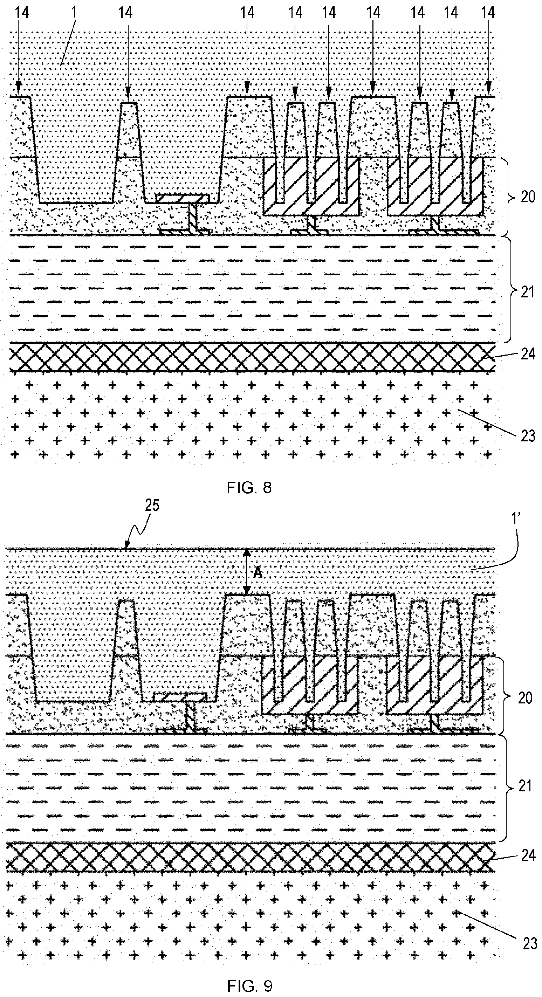

Alternatively, the planar top surface 22 of the BEOL portion 21 may be suitable for temporarily bonding the wafer face down to a temporary carrier wafer. This latter case is illustrated in Figure 8. The temporary carrier 23 and a removable adhesive layer 24 are indicated, with the BEOL portion 21 attached thereto, so that the bulk of the process wafer 1 is facing upwards. Suitable types of carrier wafers and adhesives for this purpose are equally well-known to persons skilled in the art.

With reference to Figure 9, the wafer 1 is then thinned from the back side. This may be done by any thinning method known in the art, for example by first using a grinding technique in order to remove a large portion of the wafer's bulk material in a short timespan. Possibly an etch process could be used in stead of a grinding technique. Preferably the grinding or etching process is followed by polishing, applying for example a form of chemical mechanical polishing (CMP) to further reduce the thickness at a slower rate, ending up with a smooth back surface 25 of the thinned wafer 1. Alternatively, a further etch process may be applied to arrive at the back surface 25.

At this point, the remaining silicon substrate bulk thickness A, indicated in Figure 9, is not constant across the surface of the wafer 1 with variations in the micrometer range, due to the intrinsic thickness variation of both the wafer 1 and the carrier 23 and possibly due to a degree of non-uniformity of the applied thinning techniques. The initial thinning to arrive at the situation shown in Figure 9 is however configured so that the wafer 1 is reduced to a uniform layer 1' of wafer material remaining above the dielectric-filled trenches 14, i.e. none of the dielectric-filled trenches 14 is exposed by the thinning process. Taking into account common values of thickness variations on a process wafer, an average thickness A of for example 500 nm to 1 µm will normally enable to fulfil this condition. The actual average of the thickness A may however be lower if the thickness variation of the applied substrates is lower than the commonly encountered values.

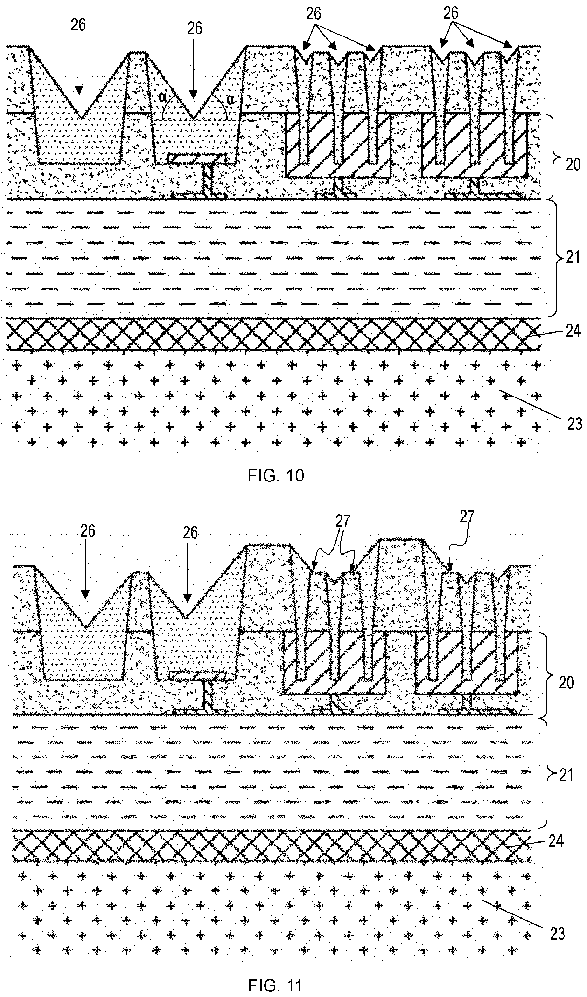

In accordance with the invention, the remaining wafer material is then further thinned by an anisotropic etch process, as illustrated in Figure 10, that removes the wafer material selectively with respect to the dielectric-filled trenches 14. The process is anisotropic in the sense that it removes the bulk semiconductor material of the wafer 1 along specific crystallographic planes of the wafer material. This type of process is known as such and used for example for making pyramid-shaped indentations in the surface of a semiconductor wafer. For example, when the wafer 1 is a Si wafer with its flat surfaces oriented along the (100) crystallographic plane, a KOH or TMAH etch process will remove the Si along the (111) planes which are oriented at about 54° with respect to the (100) plane.

Due to the anisotropic nature of the etch process and due to the selectivity of the etch process relative to the dielectric material in the trenches 14, the etch process automatically stops when the situation illustrated in Figure 10 is reached. The bottom of the (reversed) trenches is exposed, and V-shaped grooves 26 are formed in the semiconductor areas located in between two adjacent trenches. If the wafer is effectively a (100) Si wafer, the angles α are approximately 54° in each of the V-shaped grooves 26.

It is seen that the wafer has now been thinned without requiring an etch stop layer in close proximity to the device layer 20. However, in order to achieve this result, additional conditions have to be fulfilled. The location of the bottom of the V-groove where the etch process stops depends on the depth of the trenches and on the spacing between the STI trenches, i.e. the width of the semiconductor regions between two adjacent trenches. The latter parameter in particular determines whether or not the etch process reaches the front side of the wafer before it stops automatically. Therefore, in areas of the wafer where active devices are produced on the wafer's front side, it is a requirement that the spacings between adjacent dielectric-filled cavities (such as STI trenches) are configured so that the anisotropic etch does not reach active devices located on the wafer's front side. In other words, the anisotropic etch cannot be permitted to remove semiconductor material that is contributing to the operation of active devices.

This condition has to be taken into account at the design stage, by making sure that the distance between adjacent STI trenches is not higher than a given maximum.

Figure 10 also illustrates that a difference in the depth between two adjacent STI trenches 14 will shift the tip of the V-shaped groove 26 away from the center of the spacing between the two trenches. When the depth difference increases further, the groove is no longer a V-shaped groove, but the anisotropic etch will nevertheless stop due to its selectivity with respect to the dielectric material of the STI trenches. This is illustrated in Figure 11. In the case shown there, the depth difference between a number of adjacent STI trenches is higher than in the embodiment shown in Figure 10, so that the anisotropic etch stops when it reaches the material of the STI regions at locations 27. This is also an allowable embodiment of the invention. However in most chip designs, the STI depth is targeted to be relatively uniform across a wafer, so that the case shown in Figure 10 is more likely to occur.

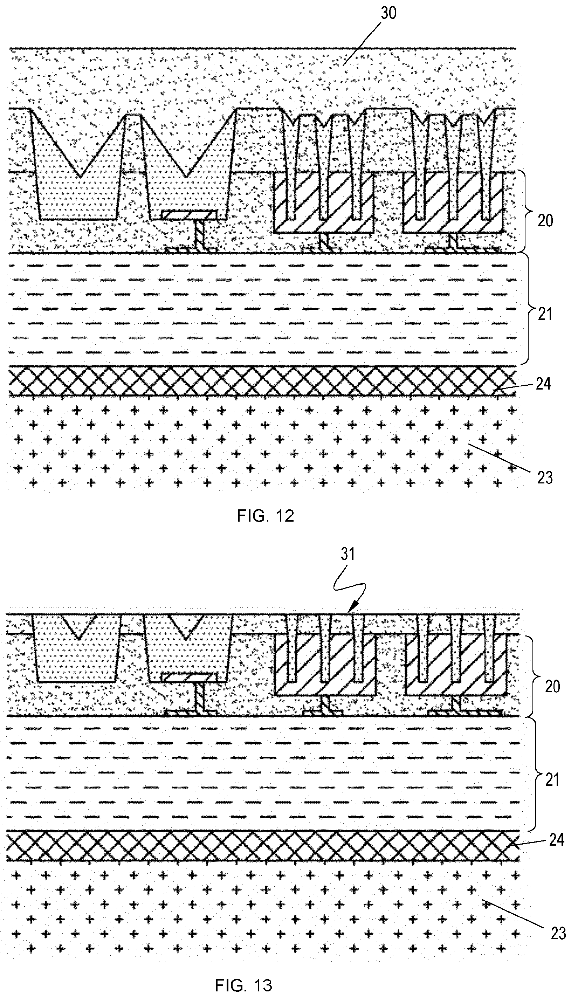

Figure 10 will therefore be used to explain the subsequent processing steps. As shown in Figure 12, a layer 30 of dielectric material is deposited that fills the V-grooves 26 and forms a uniform layer. Preferably the thickness of this layer is at least twice the depth of the deepest grooves (measured from the bottom of said deepest grooves). This layer 30 is then thinned, as shown in Figure 13, preferably by grinding and/or polishing, to a level 31 wherein most of the bulk wafer material is removed. On this planarized surface 31, further processing steps may be performed, for example for producing a back side power delivery network.

As stated above, a condition that needs to be fulfilled is that the spacings between dielectric-filled cavities 14, with devices formed within said spacings on the wafer's front side, are large enough to avoid negatively affecting the devices by the anisotropic etch process. As also indicated already, STI regions as known in chip designs can exhibit the functionality of the dielectric-filled cavities required in the method of the invention. This does not mean however that the method is applicable to any existing chip design. In order for existing designs to be compatible with the invention, it may be necessary to add STI regions or to adapt the spacings between existing STI regions.

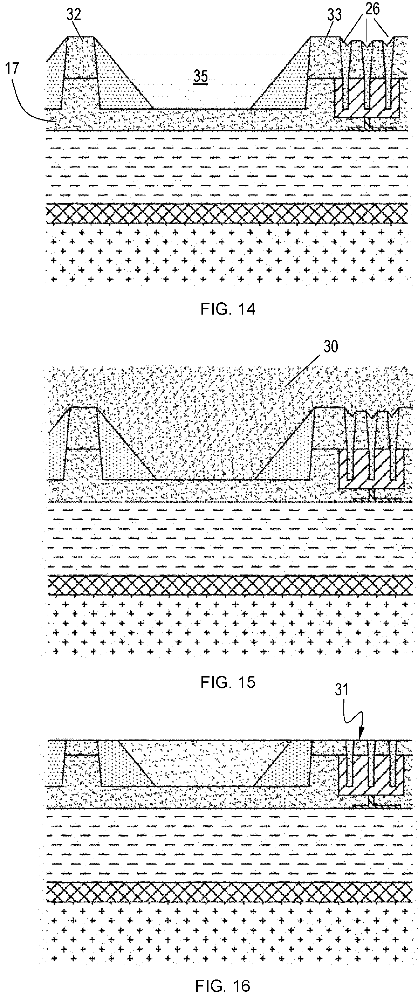

In areas of the wafer where no active devices are present, the spacings between adjacent dielectric-filled cavities could be larger, to the extent that the wafer material is removed up to the front side of the wafer in said spacings. An example of such a spacing is shown in Figure 14. The area between the dielectric-filed trenches 32 and 33 could for example be situated in a scribe line between two adjacent die areas on the wafer.

As illustrated in Figure 14, the anisotropic etch process removes the wafer material between the trenches 32 and 33 up to the front side of the wafer 1, creating a broad gap 35 between said trenches 32 and 33. This is not prohibited within the scope of the invention, provided that the etch process stops on the PMD material 17 at the bottom of the gap 35 (i.e. selectivity of the process relative to the PMD material is required). The gap 35 is thereafter filled with the dielectric material 30 applied for filling the V-grooves 26, as shown in Figure 15, after which the back side is planarized, as shown in Figure 16. According to another embodiment, the anisotropic etch could be timed so that it stops before it reaches the front side of the wafer 1 in the gap area 35.

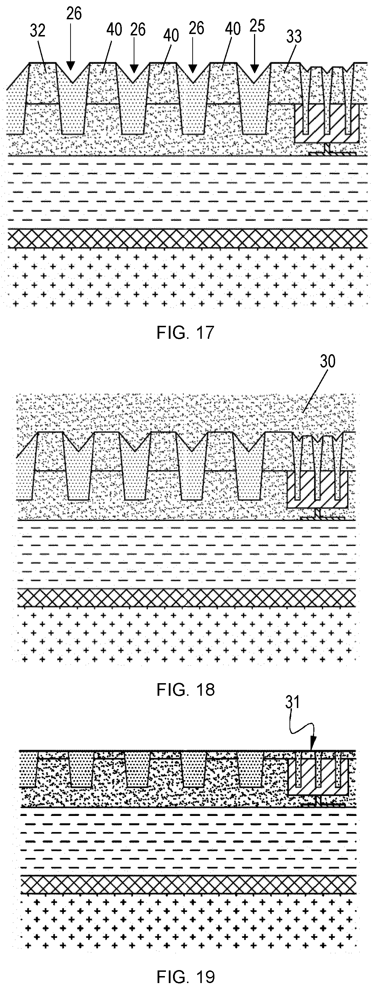

However, planarizing the large dielectric-filled gap 35 may be difficult, especially when the surface area of this gap becomes excessively large, which could lead to dishing effects. Therefore, it may be preferable to deliberately provide additional dielectric-filled trenches in the areas of the wafer where no active devices are formed. This is illustrated in Figures 17 to 19. The spacings between the additional trenches 40 is such that also in the areas where no devices are present, the anisotropic etch stops by forming V-grooves 26 before it can reach the front side of the wafer. This results in smaller gaps between adjacent trenches and a more planar back side after the final thinning step illustrated in Figure 19.

While the invention has been illustrated and described in detail in the drawings and foregoing description, such illustration and description are to be considered illustrative or exemplary and not restrictive. The scope of the invention is defined by the appended claims. In the claims, the word "comprising" does not exclude other elements or steps, and the indefinite article "a" or "an" does not exclude a plurality. Any reference signs in the claims should not be construed as limiting the scope.

## Claims

1. A method for producing a thinned semiconductor substrate, comprising the following consecutively performed steps :
- providing a first substrate (1) having a planar front side and a planar back side, the first substrate being integrally formed of a crystalline semiconductor material or comprising on its front side a layer that is integrally formed of said crystalline semiconductor material,
- producing a device layer (20) on the front side of the first substrate (1), said device layer comprising a plurality of semiconductor devices,
- producing additional layers (21) on top of the device layer (20), ending with a layer having a planar top surface (22),
- permanently or temporarily bonding the first substrate (1) to a second substrate (23) by bonding said planar top surface (22) to a bonding surface of the second substrate (23),
- thinning the first substrate (1) from the back side thereof, wherein,
- before producing the device layer (20), and in at least one or more areas of the first substrate (1) wherein said semiconductor devices are to be produced, cavities (10) are produced through the front surface of the first substrate and into the crystalline semiconductor material of the first substrate, and said cavities are filled at least partially with a dielectric material, to thereby form dielectric-filled cavities (14),
- the devices in said one or more areas are produced in a plurality of regions located between two adjacent dielectric-filled cavities (14), and said devices are covered by an additional dielectric layer (17),
- at the end of the thinning step, the first substrate is reduced to a uniform layer (1') of the crystalline semiconductor material remaining above said dielectric-filed cavities (14),
- after the thinning step, the crystalline semiconductor material is subjected to an anisotropic etch process,
- the in-plane dimensions of said regions located between two adjacent dielectric-filled cavities (14) and the depth of said adjacent cavities (14) are configured so that the anisotropic etch process stops on one or more of the following, without reaching the semiconductor devices :
o on crystallographic planes of the crystalline semiconductor material,
o on the dielectric material in the cavities (14),
o on said additional dielectric layer (17),
- the method further comprises the following steps, after the anisotropic etch process :
o depositing a further dielectric material (30) on the thinned back side of the first substrate (1),
o planarizing said further dielectric material (30) and remaining portions of the crystalline semiconductor material to a common planarized surface (31).

2. The method according to claim 1, wherein additional dielectric-filled cavities (40) are also produced in areas of the first substrate (1) wherein no semiconductor devices are to be produced.

3. The method according to claim 2, wherein the spacing between any adjacent pair of said additional dielectric-filled cavities (40) is configured so that the anisotropic etch process does not reach the front side of the first substrate (1) in said spacing.

4. The method according to any one of the preceding claims, wherein at least some of the dielectric-filled cavities (14) in said one or more areas of the first substrate (1) wherein said semiconductor devices are to be produced, are shallow trench isolation regions.

5. The method according to any one of the preceding claims, wherein the crystalline semiconductor material is crystalline silicon.

6. The method according to claim 5, wherein the first substrate is a silicon process wafer having planar front and back sides oriented along the (100) crystallographic of silicon.

7. The method according to any one of the preceding claims, wherein said in-plane dimensions and the depths of the dielectric-filled cavities (14) are configured so that at least in some of said regions between two adjacent dielectric-filled cavities, the etch process ends when a V-shaped groove (26) is formed in the material of the first substrate (1).

## Patentansprüche

1. Verfahren zur Herstellung eines ausgedünnten Halbleitersubstrats, umfassend die folgenden nacheinander durchgeführten Schritte:
- Bereitstellen eines ersten Substrats (1), das eine planare Vorderseite und eine planare Rückseite aufweist, wobei das erste Substrat in einem Stück aus einem kristallinen Halbleitermaterial gebildet ist, oder auf seiner Vorderseite eine Schicht umfasst, die in einem Stück aus dem kristallinen Halbleitermaterial gebildet ist,
- Herstellen einer Vorrichtungsschicht (20) auf der Vorderseite des ersten Substrats (1), wobei die Vorrichtungsschicht eine Vielzahl von Halbleitervorrichtungen umfasst,
- Herstellen zusätzlicher Schichten (21) oben auf der Vorrichtungsschicht (20), die mit einer Schicht enden, die eine planare obere Oberfläche (22) aufweist,
- permanent oder vorübergehend Binden des ersten Substrats (1) an ein zweites Substrat (23) durch Binden der planaren oberen Oberfläche (22) an eine Bindungsoberfläche des zweiten Substrats (23),
- Ausdünnen des ersten Substrats (1) von dessen Rückseite her, wobei
- vor dem Herstellen der Vorrichtungsschicht (20) und in mindestens einem oder mehreren Bereichen des ersten Substrats (1), in denen die Halbleitervorrichtungen herzustellen sind, Hohlräume (10) durch die vordere Oberfläche des ersten Substrats hindurch in das kristalline Halbleitermaterial des ersten Substrats erzeugt werden, und die Hohlräume mindestens teilweise mit einem dielektrischen Material gefüllt werden, um dadurch dielektrisch gefüllte Hohlräume (14) zu bilden,
- die Vorrichtungen in dem einen oder mehreren Bereichen in einer Vielzahl von Regionen hergestellt werden, die sich zwischen zwei benachbarten, dielektrisch gefüllten Hohlräumen (14) befinden, und die Vorrichtungen mit einer zusätzlichen dielektrischen Schicht (17) bedeckt sind,
- am Ende des Ausdünnungsschritts das erste Substrat auf eine gleichmäßige Schicht (T) des kristallinen Halbleitermaterials reduziert wird, die über den dielektrisch gefüllten Hohlräumen (14) verbleibt,
- nach dem Ausdünnungsschritt das kristalline Halbleitermaterial einem anisotropen Ätzprozess unterzogen wird,
- die in-planaren Abmessungen der sich zwischen zwei benachbarten dielektrisch gefüllten Hohlräumen (14) befindlichen Regionen und die Tiefe der benachbarten Hohlräume (14) konfiguriert sind, sodass der anisotrope Ätzprozess an einem oder mehreren von Folgenden stoppt, ohne die Halbleitervorrichtungen zu erreichen:
- an kristallographischen Ebenen des kristallinen Halbleitermaterials,
- am dielektrischen Material in den Hohlräumen (14),
- an der zusätzlichen dielektrischen Schicht (17),
- das Verfahren weiter die folgenden Schritte nach dem anisotropen Ätzprozess umfasst:
- Abscheiden eines weiteren dielektrischen Materials (30) auf der ausgedünnten Rückseite des ersten Substrats (1),
- Planieren des weiteren dielektrischen Materials (30) und der verbleibenden Abschnitte des kristallinen Halbleitermaterials zu einer gemeinsamen planierten Oberfläche (31).

2. Verfahren nach Anspruch 1, wobei zusätzliche dielektrisch gefüllte Hohlräume (40) auch in Bereichen des ersten Substrats (1) hergestellt werden, in denen keine Halbleitervorrichtungen herzustellen sind.

3. Verfahren nach Anspruch 2, wobei der Abstand zwischen einem beliebigen benachbarten Paar zusätzlicher dielektrisch gefüllter Hohlräumen (40) konfiguriert ist, sodass der anisotrope Ätzprozess die Vorderseite des ersten Substrats (1) in diesem Abstand nicht erreicht.

4. Verfahren nach einem der vorstehenden Ansprüche, wobei mindestens einige der dielektrisch gefüllten Hohlräume (14) in dem einen oder mehreren Bereichen des ersten Substrats (1), in denen die Halbleitervorrichtungen herzustellen sind, flache Grabenisolationsbereiche sind.

5. Verfahren nach einem der vorstehenden Ansprüche, wobei das kristalline Halbleitermaterial kristallines Silizium ist.

6. Verfahren nach Anspruch 5, wobei das erste Substrat ein Silizium-Prozesswafer ist, der planare Vorder- und Rückseiten aufweist, die entlang der (100) kristallographischen Ebene von Silizium ausgerichtet sind.

7. Verfahren nach einem der vorstehenden Ansprüche, wobei die in-planaren Abmessungen und die Tiefen der dielektrisch gefüllten Hohlräume (14) konfiguriert sind, sodass der Ätzprozess mindestens in einigen der Regionen zwischen zwei benachbarten dielektrisch gefüllten Hohlräumen endet, wenn sich im Material des ersten Substrats (1) eine V-förmige Nut (26) bildet.

## Revendications

1. Procédé de fabrication d'un substrat semi-conducteur aminci, comprenant les étapes suivantes réalisées consécutivement :
- la fourniture d'un premier substrat (1) présentant une face avant plane et une face arrière plane, le premier substrat étant formé intégralement d'un matériau semi-conducteur cristallin ou comprenant sur sa face avant une couche qui est formée intégralement dudit matériau semi-conducteur cristallin,
- la production d'une couche de dispositif (20) sur la face avant du premier substrat (1), ladite couche de dispositif comprenant une pluralité de dispositifs semi-conducteurs,
- la production de couches supplémentaires (21) sur le dessus de la couche du dispositif (20), se terminant par une couche présentant une surface supérieure plane (22),
- la liaison de manière permanente ou temporaire du premier substrat (1) à un second substrat (23) en liant ladite surface supérieure plane (22) à une surface de liaison du second substrat (23),
- l'amincissement du premier substrat (1) à partir de sa face arrière, dans lequel,
- avant la production de la couche de dispositif (20), et dans au moins une ou plusieurs zones du premier substrat (1) dans lesquelles lesdits dispositifs semi-conducteurs doivent être produits, des cavités (10) sont produites à travers la surface avant du premier substrat et dans le matériau semi-conducteur cristallin du premier substrat, et lesdites cavités sont remplies au moins partiellement d'un matériau diélectrique, pour former ainsi des cavités remplies de diélectrique (14),
- les dispositifs dans lesdites une ou plusieurs zones sont produits dans une pluralité de régions situées entre deux cavités remplies de diélectrique (14) adjacentes, et lesdits dispositifs sont recouverts d'une couche diélectrique supplémentaire (17),
- à la fin de l'étape d'amincissement, le premier substrat est réduit à une couche uniforme (T) du matériau semi-conducteur cristallin restant au-dessus desdites cavités remplies de diélectrique (14),
- après l'étape d'amincissement, le matériau semi-conducteur cristallin est soumis à un processus de gravure anisotrope,
- les dimensions dans le plan desdites régions situées entre deux cavités remplies de diélectrique (14) adjacentes et la profondeur desdites cavités adjacentes (14) sont configurées de sorte que le processus de gravure anisotrope s'arrête sur un ou plusieurs des éléments suivants, sans atteindre les dispositifs semi-conducteurs :
- sur des plans cristallographiques du matériau semi-conducteur cristallin,
- sur le matériau diélectrique dans les cavités (14),
- sur ladite couche diélectrique supplémentaire (17),
- le procédé comprend en outre les étapes suivantes, après le processus de gravure anisotrope :
- le dépôt d'un matériau diélectrique supplémentaire (30) sur la face arrière amincie du premier substrat (1),
- la planarisation dudit matériau diélectrique supplémentaire (30) et des parties restantes du matériau semi-conducteur cristallin sur une surface planarisée commune (31).

2. Procédé selon la revendication 1, dans lequel des cavités remplies de diélectrique supplémentaires (40) sont également produites dans des zones du premier substrat (1) dans lesquelles aucun dispositif semi-conducteur ne doit être produit.

3. Procédé selon la revendication 2, dans lequel l'espacement entre toute paire adjacente desdites cavités remplies de diélectrique supplémentaires (40) est configuré de sorte que le processus de gravure anisotrope n'atteigne pas la face avant du premier substrat (1) dans ledit espacement.

4. Procédé selon l'une quelconque des revendications précédentes, dans lequel au moins certaines des cavités remplies de diélectrique (14) dans lesdites une ou plusieurs zones du premier substrat (1) dans lesquelles lesdits dispositifs semi-conducteurs doivent être produits, sont des régions d'isolation de tranchée peu profondes.

5. Procédé selon l'une quelconque des revendications précédentes, dans lequel le matériau semi-conducteur cristallin est du silicium cristallin.

6. Procédé selon la revendication 5, dans lequel le premier substrat est une plaquette de silicium ayant des faces avant et arrière planes orientées le long du plan cristallographique (100) du silicium.

7. Procédé selon l'une quelconque des revendications précédentes, dans lequel lesdites dimensions dans le plan et les profondeurs des cavités remplies de diélectrique (14) sont configurées de telle sorte que, au moins dans certaines desdites régions entre deux cavités remplies de diélectrique adjacentes, le processus de gravure se termine lorsqu'une rainure en forme de V (26) est formée dans le matériau du premier substrat (1).
